# EUROPEAN PATENT APPLICATION

(11) **EP 1 531 547 A2**
(43) Date of publication of application: **18.05.2005**
(21) Application number: 04026203.2
(22) Date of filing: 04.11.2004
(51) Int. Cl.: H03J 1/00, H04B 1/20, H04N 1/21

(54) **Electronic device, remote control method therefor, and computer program for the electronic device**

(30) Priority: 12.11.2003 JP 2003382036
(71) Applicant: NEC CORPORATION, Tokyo (JP)
(72) Inventor: Sato, Yoshihiro, Minato-ku, Tokyo (JP)
(74) Representative: VOSSIUS & PARTNER

(57) **Abstract**

A signal pattern of a signal received from a remote control terminal (105) desired by a user while a camera mobile phone (102) is operating in a learning mode is registered in association with a shutter release operation of the mobile phone concerned. Then, the mobile phone (102) executes the shutter release operation in a case where a signal pattern of a signal received from the remote control terminal (105) while the mobile phone (102) is operating in a remote control standby mode and the signal pattern registered during the learning mode coincide with each other.

## Description

The present invention relates to a technical field of electronic devices such as a mobile phone and a video camera. In particular, the present invention relates to a technical field of an electronic device capable of remote control using an infrared signal and the like.

Heretofore, there are various kinds of electronic devices such as a digital camera, a video camera, and a digital versatile disc (DVD) recorder which are capable of remote control using an infrared signal. In general, when introducing a product such an electronic device equipped with a remote control function on the market, a manufacturer adds a terminal dedicated to the remote control (hereinafter, referred to as an "RC terminal") for sale together with a main body of the electronic device. Alternatively, in many cases, the manufacturer only sells the RC terminal as a single piece of an optional part separately from the electronic device.

However, in the case of adopting such a sales mode, there is a problem in that total cost (of development cost, inventory cost, and the like) of the electronic device is increased by the amount of cost of the dedicated RC terminal. As a result, the RC terminal will greatly affect salability of the electronic device.

As described above, the RC terminal becomes a large obstacle to cost reduction of the entirety of the product. Moreover, in general, the RC terminals are frequently attached as dedicated terminals to the various kinds of electronic devices when the electronic devices are shipped although the RC terminals are less frequently used. Therefore, a user must use plural RC terminals properly at home or away from home, and feels troublesome. This problem becomes conspicuous in the electronic devices such as the digital camera, the video camera, and the mobile phone, which have a compact, lightweight body and are excellent in portability.

Specifically, when the user goes out while carrying these electronic devices, the user must also carry the RC terminals different for each of the electronic devices. Therefore, even though the individual electronic devices in themselves are excellent in portability, the user must also carry the plural RC terminals in the case of carrying the plural electronic devices. As a result, the number of personal effects is increased, and the personal effects become rather voluminous. Accordingly, there is a problem in that the user cannot carry such plural electronic devices.

Incidentally, JP 07-7771 A exists as a conventional technology present prior to this application. In JP 07-7771 A, a general-purpose remote commander (hereinafter, referred to as a "general-purpose RC terminal") capable of coping with plural kinds of electronic devices is proposed.

In this general-purpose RC terminal, preset data is registered in advance. This preset data is information such as control codes, signal patterns, and the like which are employed for the remote control of the plural kinds of electronic devices in which manufacturers and types are mutually different. According to such a general-purpose RC terminal, the same terminal can be set as a remote control terminal for an electronic device desired by the user.

Specifically, in JP 07-7771 A, at the time of making a setting, the user first prepares the RC terminal dedicated to the desired electronic device (hereinafter, referred to as a "dedicated terminal"). Then, the user holds both of the dedicated terminal and the general-purpose RC terminal such that transmitting/receiving units of both of the terminals are physically opposed to each other. Then, in such a state, the user operates any operation key (for example, a channel operation key) for a remote control instruction to the dedicated terminal. In this case, the transmitting/receiving unit of the general-purpose RC terminal receives a signal sent out from the dedicated terminal. Then, the general-purpose RC terminal refers to the preset data registered therein in advance based on a pattern of the signal received from the dedicated terminal, and thus automatically identifies a model of the dedicated terminal. Then, the general-purpose RC terminal according to JP 07-7771 A sets an operation mode thereof to be compatible with the identified model.

Hence, according to the technology described in JP 07-7771 A, the user can easily set the general-purpose RC terminal as the terminal for the electronic device desired by the user without performing a troublesome key operation. However, for the general-purpose RC terminal according to JP 07-7771 A, it is necessary to prepare therein preset data of which types are as many as possible in order to assure the salability. Accordingly, the general-purpose RC terminal according to JP 07-7771 A cannot solve the problem in terms of cost such as the development cost.

Moreover, consideration will be made to a case where such a general-purpose RC terminal is set, for example, for remote control of a digital camera which is the electronic device desired by the user. In this case, it is necessary for the user to carry the digital camera and the general-purpose RC terminal when the user goes out. Hence, circumstances (limitations) that it is necessary to carry not only the main body of the digital camera but also the dedicated RC terminal when the user goes out remain as in the conventional way of carrying the dedicated RC terminal attached to the electronic device.

Incidentally, there is a possible case where, from the viewpoint of reducing the number of personal effects when the user goes out, for example, the user goes out while carrying only the body of the digital camera and keeping the RC terminal dedicated for the digital camera left at home as a result of predicting behaviors thereof away from home. However, in this case, a situation is also easily assumed, where the user regrets not having brought the RC terminal away from home. For example, the situation is that another appropriate person to whom a shutter release is requested cannot be found before taking a group picture at a scenic area and the like.

The present invention has been made in view of the above-mentioned circumstances. It is an object of the present invention to easily and reliably realize remote control of an electronic device subjected to the remote control without using a remote control terminal (RC terminal) dedicated for the electronic device.

In order to achieve the above-mentioned object, a remote control method of an electronic device according to the present invention is characterized by including the following configurations.

That is, the present invention relates to a remote control method for an electronic device (102), which includes:
conditioning (11) the electronic device in a first operation mode (learning mode);
registering (12, S1 to S3) a signal pattern of a signal received from a remote control terminal (105) desired by a user in association with a predetermined operation of the electronic device when the electronic device conditions in the first operation mode;
operating (11) the electronic device in a second operation mode (remote control standby mode) different from the first operation mode; and
executing (13, 14, S11 to S15) the predetermined operation in a case where a signal pattern of a signal received from the remote control terminal when the electronic device operates in the second operation mode and the signal pattern registered by the registration coincide with each other.

Further, in order to achieve the above-mentioned object, an electronic device according to the present invention is characterized by including the following configurations.

That is, the present invention relates to an electronic device (102) capable of accepting an operation instruction by remote control, which includes:
signal registration means (12, 101, 201, 207) for registering a signal pattern of a signal received from an outside in a first operation mode (learning mode) in association with a predetermined operation of the electronic device; and
operation control means (13, 14, 207) for executing the predetermined operation in a case where a signal pattern of a signal received from the outside in a second operation mode (learning mode) different from the first operation mode and the signal pattern registered by the signal registration means coincide with each other.

In a preferred embodiment, the signal registration means includes sensing means (201, 202) for sensing the signal received from the outside.

Further, the electronic device is, for example, a mobile phone (102) having a camera function, and an image sensor (101) for the camera function may be used as the sensing means.

Further, the operation control means, for example, may store an image sensed by the image sensor as the predetermined operation.

Moreover, the same object can also be achieved by a computer program causing a computer to implement the electronic device and the remote control method therefor in the above-mentioned respective configurations, and by a computer-readable recording medium storing the computer program.

Other features and advantages of the present invention will be apparent from the following description taken in conjunction with the accompanying drawings, in which like reference characters designate the same or similar parts throughout the figures thereof.

The above and other objects, features and advantages of the present invention will become more apparent from the following detailed description when taken in conjunction with the accompanying drawings characterized in that:
FIG. 1 is an external view showing a mobile phone as an electronic device and an RC terminal for remote control according to a first embodiment of the present invention;
FIG. 2 is a block diagram showing an internal configuration of the mobile phone (in FIG. 1) according to the first embodiment of the present invention;
FIG. 3 is a block diagram explaining a software program executed by a microcomputer in the mobile phone according to the first embodiment of the present invention;
FIG. 4 is a flowchart showing control processing in a learning mode of the mobile phone according to the first embodiment of the present invention; and
FIG. 5 is a flowchart showing control processing in a remote control standby mode of the mobile phone according to the first embodiment of the present invention.

Preferred embodiments of the present invention will now be described in detail in accordance with the accompanying drawings.

The present invention is described below in detail with reference to the accompanying drawings, as embodiments in which the present invention is applied to a mobile phone as a typical electronic device.

### First Embodiment

### Hardware configuration

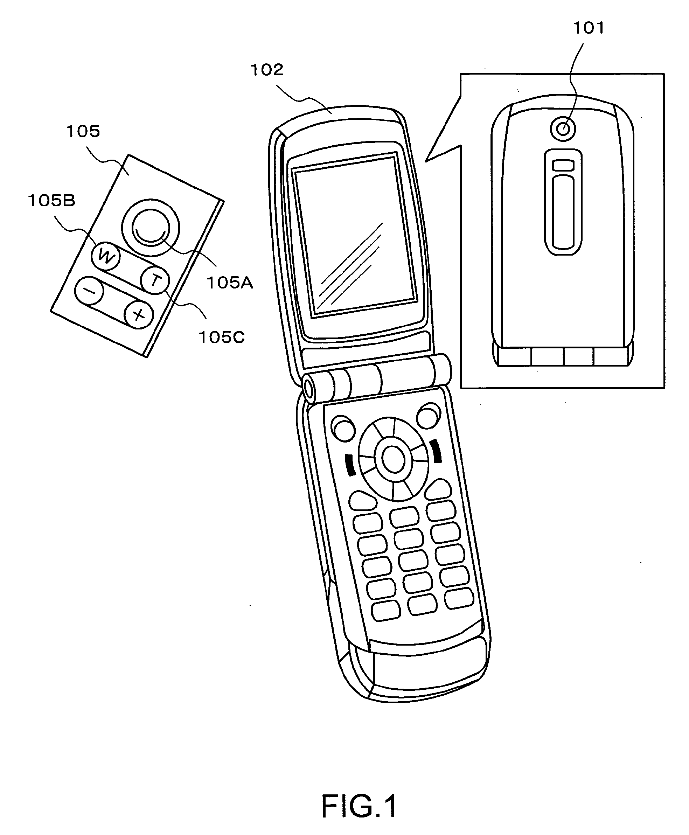

FIG. 1 is an external view showing a mobile phone as an electronic device and an RC terminal for remote control (a remote control terminal) according to a first embodiment of the present invention.

A mobile phone 102 shown in the same drawing is a so-called digital camera phone, which includes an image sensor 101. A user performs a setting operation to be described later for the mobile phone 102, and thus, by using an arbitrary RC terminal (105), can perform a shutter release operation by the remote control for an image taken by the image sensor 101.

The RC terminal 105 is not one dedicatedly prepared for the remote control of the mobile phone 102, but is an RC terminal for another purpose. Specifically, the RC terminal 105 may be, for example, an RC terminal for a television set equipped in a hotel where the user is staying in the case of using the mobile phone 102 at the hotel. Moreover, the RC terminal 105 may be an RC terminal for operating a car navigation system equipped in a passenger car in the case of using the mobile phone 102 on the way to a destination to which the user is moving by the passenger car. Alternatively, in recent years, many portable electronic devices such as mobile phones and personal digital assistances (PDAs), each of which has a remote control function, have also been on the market. Accordingly, an RC terminal for such an electronic device may be used as the RC terminal 105. Moreover, when the user carries a video camera together with the mobile phone 102, an RC terminal dedicated for the video camera may also be used.

In this embodiment, the description described hereinafter takes as an example the case of using, as a button for the shutter release operation of the image sensor 101 built in the mobile phone 102, a button 105A located on an upper center of the RC terminal 105 among plural buttons provided thereon.

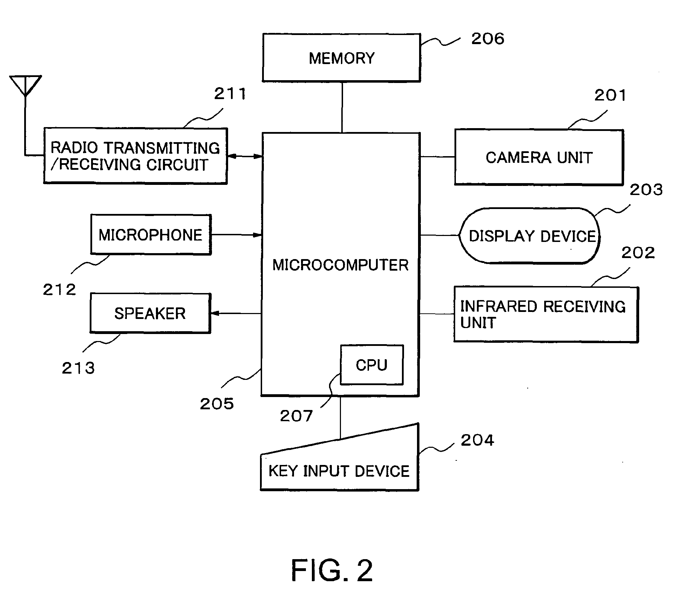

FIG. 2 is a block diagram showing an internal configuration of the mobile phone (in FIG. 1) according to the first embodiment. In this embodiment, the mobile phone 102 includes a camera unit 201 (including the image sensor 101), an infrared receiving unit 202, a display device 203, a key input device 204, a microcomputer 205, a memory 206, a radio transmitting/receiving circuit 211, a microphone 212, and a speaker 213.

The camera unit 201 creates digital image data corresponding to a video signal outputted from the image sensor 101.

The infrared receiving unit 202 receives an infrared signal sent out from an external device (the RC terminal 105 in this embodiment). Moreover, the infrared receiving unit 202 creates information representing a signal pattern of the received infrared signal. This information is sent to the microcomputer 205.

The display device 203 is a display device including a liquid crystal display unit and the like, and functions as a so-called finder when an operation mode of the mobile phone 102 is a "camera mode". In the case where the operation mode is simply the "camera mode", the mobile phone 102 can record an image taken by the image sensor 101 when a shutter release operation by use of a predetermined operation button is performed in response to the shutter release operation.

The microcomputer 205 executes, in a central processing unit (CPU) 207, a software program read out from the memory 206, and thus administers an entire operation of the mobile phone 102. In this embodiment, in the "camera mode"', the microcomputer 205 controls the camera unit 201 in response to the shutter release operation of the user. Moreover, into the memory 206, the microcomputer 205 registers the signal pattern of the infrared signal, which is acquired from the external device in a "learning mode (signal registration mode) " that is a first operation mode, as information representing a signal pattern of an infrared signal instructing the shutter release operation.

Furthermore, the microcomputer 205 allows the infrared receiving unit 202 to receive the infrared signal sent out from the RC terminal 105, in the "camera mode" and a "remote control standby mode", each of which is a second operation mode. This infrared signal corresponds to the shutter release operation by the user. In this case, when the signal pattern (information representing the signal pattern) of the received infrared signal coincides with the information representing the signal pattern registered in the memory 206, the microcomputer 205 stores, in the memory 206, the digital image data outputted from the camera unit 201.

The "learning mode" and the "remote control standby mode" are described later in detail.

The key input device 204 is an operation key (operation button) used for the user to issue an operation instruction to the mobile phone 102. In this embodiment, the key input device 204 includes an operation key (not shown) which functions as a shutter in the camera mode.

The memory 206 is a non-volatile memory (flash memory or the like), and records and stores the information representing the signal pattern of the infrared signal. Furthermore, the memory 206 stores, for example, an operation program of the microcomputer 205 (CPU 207), various kinds of parameters, and user data (for example, mail documents and phone numbers).

The radio transmitting/receiving circuit 211 performs demodulation of a radio wave received from an antenna and phase modulation for a digital signal outputted from the microcomputer 205. Moreover, the radio transmitting/receiving circuit 211 has a function similar to that of a radio transmitting/receiving circuit of a publicly known wireless communication terminal.

Moreover, voice of the user is inputted to the microphone 212. The speaker 213 outputs voice (acoustic sound) to the user.

In this embodiment, ones generally used at present may be employed for the following:
- method of receiving the infrared signal in the infrared receiving unit 202;
- pattern (pattern format) of the received signal;
- recording method of the information representing the signal pattern in the memory 206; and the like.
Therefore, detailed description of the above in this embodiment is omitted.

Moreover, technologies generally adopted at present can be employed for operations in themselves of data transmitting/receiving processing, voice processing, and the like which are executed between the external device and the mobile phone 102 in the above-mentioned device configuration. Therefore, detailed description of the above in this embodiment is omitted.

### Software configuration

Next, a configuration of the software program executed by the microcomputer 205 (CPU 207) when the operation modes of the mobile phone 102 are the "learning mode" and the "remote control standby mode" is described.

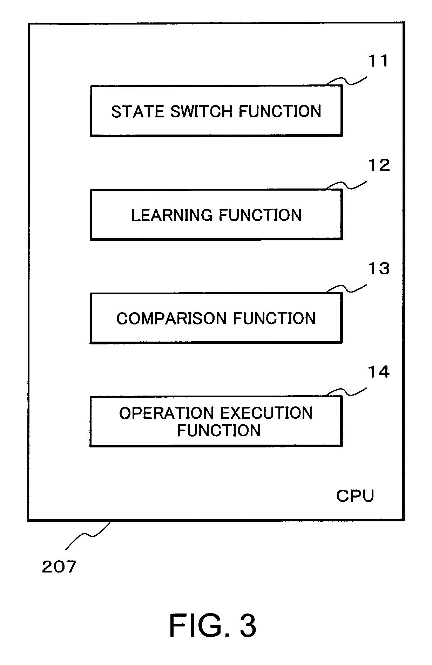

FIG. 3 is a block diagram explaining the software program executed by the microcomputer in the mobile phone according to the first embodiment. The respective functions shown in the same drawing are conceptually shown operation functions to be realized by the microcomputer 205 (CPU 207).

Specifically, a state switch function 11 is a function to switch the operation mode of the mobile phone 102 to the "learning mode", the "remote control standby mode", or other operation modes (for example, a standby mode for a phone call and electronic mail).

Here, the "learning mode" is an operation mode for associating an operation (shutter release operation in this embodiment) of the mobile phone 102, which is desired to be executed by the remote control, with any operation key (button 105A of the RC terminal 105 in this embodiment) of the RC terminal desired by the user.

Meanwhile, the "remote control standby mode" is an operation mode of awaiting an input of the infrared signal from the outside to the infrared receiving unit 202 in order to realize the remote control in an operation mode ("camera mode" in this embodiment) other than the "learning mode".

A learning function 12 is executed when the operation mode of the mobile phone 102 is the "learningmode (signal registration mode)". The learning function 12 is a function for learning (analyzing) the signal pattern of the infrared signal received from the RC terminal (RC terminal 105 shown in FIG. 1 in this embodiment) desired by the user. The infrared signal is one outputted from the RC terminal 105 as the user presses the button 105A. Moreover, the learning function 12 is a function for registering, in the memory 206, the information representing the signal pattern as information corresponding to a predetermined operation instruction (shutter release operation in this embodiment) of the mobile phone 102.

A comparison function 13 is executed when the operation mode of the mobile phone 102 is the "remote control standby mode". The comparison function 13 is a function for comparing the information representing the signal pattern registered in the memory 206 by the learning function 12 with the signal pattern (information representing the signal pattern) of the infrared signal received in the infrared receiving unit 202 in response to the operation of the button 105A in the RC terminal 105.

Then, an operation execution function 14 is executed when the operation mode of the mobile phone 102 is the "remote control standby mode". The operation execution function 14 is a function for executing the instructed predetermined operation (shutter release operation in this embodiment) of the mobile phone 102 when a comparison result by the comparison function 13 shows coincidence.

### Operation explanation

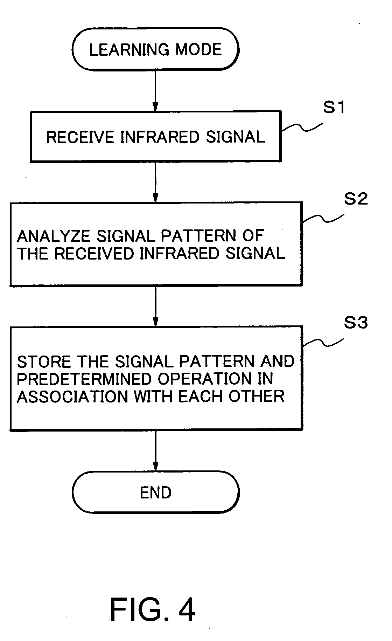

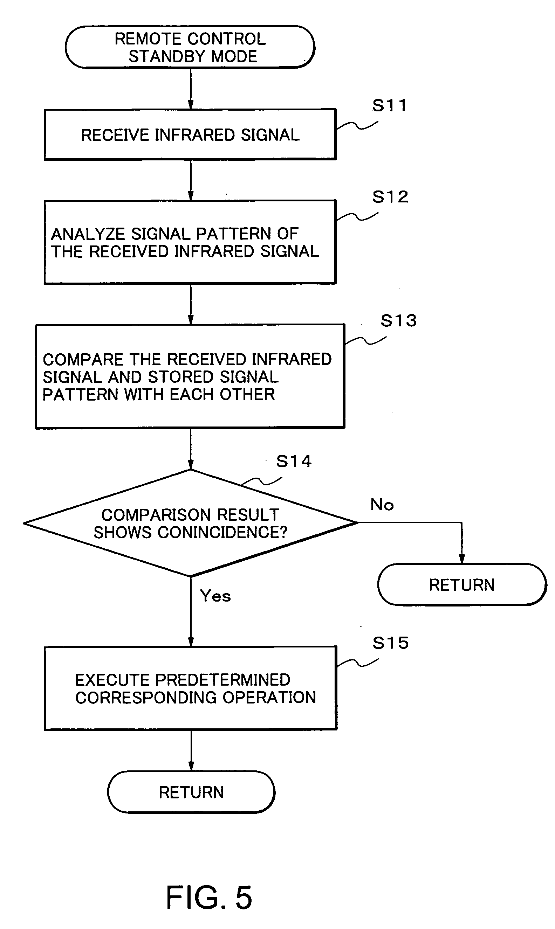

Next, the operation of the mobile phone 102 having the above-mentioned configurations is described with reference to FIGS. 4 and 5.

FIG. 4 is a flowchart showing control processing (learning function 12) in the learning mode of the mobile phone according to the first embodiment. This flowchart shows a processing procedure of the software program executed by the CPU 207 in the microcomputer 205 shown in FIG. 1.

Description is made below for the case, as an example, where the user desires to perform the association of the button 105A of the RC terminal 105 as a button for the remote control of the shutter in the mobile phone 102.

First, the user performs a predetermined operation in the key input device 204, and thus instructs the mobile phone 102 to execute (condition) the "learning mode". In this case, the CPU 207 executes the state switch function 11, and thus shifts the operation mode of the mobile phone 102 to the "learning mode". Moreover, in response to such switch of the operation modes, the CPU 207 starts the control processing (in FIG. 4) for associating the instruction on the predetermined operation (shutter release operation in this embodiment) of the mobile phone 102 with the button (button 105A of the RC terminal 105 in this embodiment) of the RC terminal desired by the user.

The CPU 207 activates the infrared receiving unit 202 in order to receive an infrared signal (sample signal) to be used for the learning from the outside (Step S1). Here, the infrared signal (sample signal) received in Step S1 is one for the learning. Such an infrared signal has the same signal pattern as that of an infrared signal received in the "remote control standby mode" to be described later.

First, the user confirms that the operation mode of the mobile phone 102 has shifted to the "learning mode". Here, the confirmation of the operation mode may be realized, for example, by display of a symbol on the display device 203, and output of a confirmation sound. Then, the user who has confirmed that the mobile phone 102 is under operation in the "learning mode" directs the RC terminal 105 toward the image sensor 101, and operates the button 105A in this state.

In response to this operation, the infrared receiving unit 202 receives the infrared signal outputted from the RC terminal 105. Moreover, the infrared receiving unit 202 analyzes the signal pattern of the infrared signal received in Step S1, and thus creates information representing the signal pattern of the infrared signal (Step S2).

The CPU 207 registers the information representing the signal pattern in the memory 206 in association with the information concerned with the information instructing the predetermined operation (shutter release operation of a digital camera function in this embodiment) in the mobile phone 102 (Step S3).

By the above-mentioned "learning mode", the button 105A of the RC terminal 105 and the shutter release operation of the mobile phone 102 have been able to be associated with each other. Accordingly, in order to actually perform the shutter release operation by the remote control, the user performs the predetermined operation in the key input device 204, and thus instructs the mobile phone 102 to execute the "remote control standby mode" and the "camera mode". In this case, the state switch function 11 shifts the operation mode of the mobile phone 102 to the "remote control standby mode" and the "camera mode". In response to this shift, the CPU 207 starts control processing (in FIG. 5) for performing the instructedpredeterminedoperation (shutter release operation in this embodiment) of the mobile phone 102 by the remote control in the RC terminal (RC terminal 105) desired by the user.

FIG. 5 is a flowchart showing control processing (the comparison function 13 and the operation execution function 14) in the remote control standby mode of the mobile phone according to the first embodiment.

The CPU 207 activates the infrared receiving unit 202 in order to receive the infrared signal for the remote control from the outside (Step S11).

The user who has confirmed that the operation mode of the mobile phone 102 has shifted to the "remote control standby mode" and the "camera mode" directs the RC terminal 105 toward the image sensor 101 of the mobile phone 102, and in this state, operates the button 105A. In response to this operation, the infrared receiving unit 202 receives the infrared signal outputted from the RC terminal 105. Moreover, the infrared receiving unit 202 analyzes the signal pattern of the infrared signal received in Step S11, and thus creates the information representing the signal pattern of the infrared signal (Step S12).

The CPU 207 compares the information representing the signal pattern, which is created in Step S12, with the information representing the signal pattern registered in the memory 206 (Step S13).

When a result of the comparison in Step S13 shows coincidence (YES in Step S14), the infrared signal received in Step S11 can be determined to be one instructing the shutter release operation by the operation of the button 105A of the RC terminal 105. Accordingly, when the result of the comparison in Step S13 shows the coincidence, the CPU 207 instructs the camera unit 201 on the shutter release operation (Step S15). In this case, the image taken by the image sensor 101 is displayed on the display device 203. The camera unit 201 stores image data corresponding to the taken image in the memory 206 in response to the instruction from the CPU 207 in Step S15.

Meanwhile, when the result of the comparison in Step S13 does not show the coincidence (NO in Step S14), the infrared signal received in Step S11 can be determined not to be one of the RC terminal registered normally. Accordingly, the CPU 207 returns the processing to Step S11.

### <Effect of first embodiment>

In the first embodiment described above, effects as described below are produced.

According to this embodiment, it is possible for the mobile phone 102 to learn the infrared signal transmitted by the RC terminal. Thus, even if the RC terminal dedicated for the mobile phone concerned is not prepared, the mobile phone 102 can be easily and reliably subjected to the remote control by an RC terminal of the other electronic device or for the other purpose.

Specifically, in recent years, as various kinds of electronic devices, each of which has the remote control function, have been widespread, an environment has appeared, in which various kinds of RC terminals are present close to the user, for example, indoors, or a place where the user is staying (away from home). The applicant has paid attention to this environment, and the mobile phone 102 according to this embodiment is configured such that the RC terminal desired by the user among such RC terminals is usable for the remote control of the shutter. Thus, the user can reduce the number of personal effects when going out.

Moreover, according to this embodiment, it is not necessary to attach the dedicated RC terminal to a product or to prepare the dedicated RC terminal as an optional part in realizing the remote control of the mobile phone 102. Hence, according to this embodiment, total cost of the mobile phone 102 can be reduced with no specification reduction. Hence, this embodiment is suitable in that salability of the mobile phone 102 can be enhanced.

Moreover, according to this embodiment, even if the user does not know a manufacturer, specifications or the like of the required RC terminal, the RC terminal present close to the user can be easily and reliably registered as one for the remote control of the mobile phone 102, and thus this embodiment is excellent in usability.

### Second Embodiment

Next, a second embodiment based on the mobile phone 102 according to the above-mentioned first embodiment is described.

In the following description, characteristic portions according to this embodiment are mainly described, and repetitive description regarding similar configurations to those of the above-mentioned first embodiment is omitted.

In the above-mentioned first embodiment, the case of associating the button 105A of the RC terminal 105 with the shutter release operation of the mobile phone 102 has been described. In contrast to this, in this embodiment, the case of associating buttons of the RC terminal 105 individually with plural operation functions of the mobile phone 102 is described.

This embodiment is also described specifically with reference to the mobile phone 102 (in FIG. 1) having the built-in image sensor 101.

Here, in this embodiment also, the RC terminal 105 is not one dedicatedly prepared for the mobile phone 102, but for example, is the RC terminal for the video camera included in the personal effects of the user.

In this embodiment, among the plural operation buttons of the RC terminal 105, not only the button 105A located on the upper center thereof but also a button 105B for "W (wide-angle) " and a button 105C for "T (telephoto, telescopic)", which are located immediately under the button 105A, are used.

In this embodiment, it is assumed that the camera unit 201 of the mobile phone 102 is capable of a telescopic (T) operation and a wide-angle (W) operation. Moreover, this embodiment is described taking as an example the case of realizing a correspondence to be described below, for convenience' sake of description.

Specifically, the button 105B for the wide-angle, which is included in the RC terminal 105 for the video camera, is associated with the wide-angle operation of the mobile phone 102 (camera unit 201). Moreover, the button 105C for the telescopic operation, which is included in the RC terminal 105, is associated with the telescopic operation of the mobile phone 102 (camera unit 201). Owing to such association, in this embodiment, while an angle of view by the image sensor 101 of the mobile phone 102 is widened in response to an operation of the button 105B, the angle of view is narrowed in response to an operation of the button 105C.

In this embodiment also, in order to associate each operation button of the RC terminal 105 and the operation of the mobile phone 102 with each other, the user performs a predetermined operation in the key input device 204, and thus instructs the mobile phone 102 to execute the "learning mode". In this case, the state switch function 11 shifts the operation mode of the mobile phone 102 to the "learning mode". In this embodiment also, the CPU 207 executes the control processing (learning function 12 in FIG. 4) in the learning mode. However, in this embodiment, there are plural operations to be registered in the mobile phone 102. Accordingly, it is necessary for the user to select any operation (function) from the plural operations to be registered prior to the operation of any desired button of the RC terminal 105. Here, as a specific example according to this embodiment, desired button operations are performed for the buttons 105A to 105C. Moreover, the plural operations to be registered are the shutter release operation, the wide-angle operation, and the telescopic operation.

In order to associate the above-mentioned selection operations and operation buttons with each other, in this embodiment, the processing in Step S1 of the learning mode (in FIG. 4), which has been described in the first embodiment, may be set, for example, as the following processing.

Specifically, in Step S1 of the learning mode according to this embodiment, the CPU 207 displays the plural registrable operations (functions) as alternatives on the display device 203. The user selects a desired operation from the displayed alternatives by a selection operation using the key input device 204. Then, in this case, in response to sensing of the selection operation, the CPU 207 displays operation guidance on the display device 203. It is recommended that this operation guidance includes guidance information, for example, such as: "Operation (function) to be registered was selected in this mobile phone. It is need to operate a desired button of a desired RC terminal so as to associate the selected operation with the desired button. Please, operate the desired button while directing the desired RC terminal toward this mobile phone".

Then, after Step S1 above, the CPU 207 executes the processing of Step S2 and Step S3 in a similar way to the first embodiment. However, in this embodiment, the plural operations are registered in the memory 206, and accordingly, it is necessary to allocate different regions in the memory 206 for each registration operation.

The RC terminal 105 sends out infrared signals of signal patterns different for each button. Therefore, the user repeats the registration operation in the "learning mode" according to this embodiment described above, and thus information is registered for each of the buttons in the memory 206 of the mobile phone 102. Specifically, in the memory 206, the information representing the signal patterns different for each of the buttons will be registered in a state of being associated individually with the corresponding operations. According to the above-mentioned specific example, information representing a signal pattern by the button 105A and the shutter release operation of the mobile phone 102 are registered in association with each other. Information representing a signal pattern by the button 105B and the wide-angle operation of the mobile phone 102 are registered in association with each other. Moreover, information representing a signal pattern by the button 105C and the telescopic operation of the mobile phone 102 are registered in association with each other.

The user's operation for selecting any from the plural operations for a certain signal pattern is not limited to the processing performed in Step S1 (in FIG. 4). For example, the processing may be arranged such that the user's operation is performed prior to the registration of the operation in the memory 206 in Step S3 (in FIG. 4).

Moreover, a man-machine interface provided by the mobile phone 102 upon the above-mentioned user's operation is not limited to the display device 203 and the key input device 204. For example, the processing may be arranged such that an operation (function) which the user desires to select is selected by operating an operation key originally for an operation of the mobile phone 102.

By the above-mentioned "learning mode", the buttons 105A to 105C of the RC terminal 105 and the shutter release operation, telescopic operation, and wide-angle operation of the mobile phone 102 have been able to be associated with each other, respectively. Accordingly, in order to actually perform the remote control of the camera unit 201, the user performs a predetermined operation in the key input device 204, and thus instructs the mobile phone 102 to execute the "remote control standby mode" and the "camera mode". In this case, the state switch function 11 shifts the operation mode of the mobile phone 102 to the "remote control standby mode" and the "camera mode". In response to such switch of the operation modes, the CPU 207 starts the control processing (in FIG. 5) for the remote control also in this embodiment. However, in this embodiment, there are plural operations to be executed. Therefore, this embodiment is different from the first embodiment in that there are plural signal patterns to be compared with the signal pattern of the received infrared signal in Step S13.

### <Effect of second embodiment>

Also in this embodiment as described above, similar effects to those of the first embodiment can be attained. Furthermore, in this embodiment, not only the shutter release operation but also the other plural operations of the mobile phone 102 can be registered individually to the buttons of the RC terminal 105, and accordingly, the usability can be enhanced more.

### [Modification example of embodiments]

In the above-mentioned respective embodiments, infrared communication has been performed between the RC terminal 105 and the infrared receiving unit 202 (mobile phone 102), as an example of communication means for the remote control. However, a communication mode between the RC terminal and the mobile phone 102 is not limited to use of an infrared ray, and various communication modes using an electric wave, visible light, and the like can be employed.

Moreover, when photosensitivity of the image sensor 101 for use in the camera function widely ranges from the visible light (natural light) to the infrared light, the high sensitivity image sensor 101 can be used as a sensing mechanism of the infrared signal which is the sample signal. However, in this case, it is necessary for the mobile phone 102 to appropriately filter (remove), by internal image processing, the infrared signal received together with the visible light in the image sensor 101 in response to the shutter release operation of the user in an actual image taking operation after the "learning mode (registration)". Alternatively, a time difference is set between timing of sensing processing of the infrared signal by the shutter release operation and timing of starting creation processing (image recording operation) of a picture image in response to the shutter release operation, and thus the internal configuration of the mobile phone 102 may be simplified.

According to this modification example, the image sensor 101 originally provided in the mobile phone 102 can be used for the input of the infrared signal (sample signal) in the "learning mode" without providing a new sensing mechanism. In general, addition of hardware greatly affects a size of the mobile phone. In contrast to this, according to this modification example, it is not necessary to largely change a basic configuration of a so-called camera mobile phone. Therefore, according to this modification example, the usability and salability of the mobile phone can be enhanced without causing a cost increase accompanying upsizing of a casing of the mobile phone 102 and an increase of the hardware for use therein, which may result from mounting of the infrared receiving unit 202, and this modification example is suitable.

Moreover, this modification example can be applied not only to the case of using the RC terminal for the infrared communication but also to the case of using an RC terminal in which visible light communication is employed. However, in this case, it is conceivable that there are many usage modes, where visible light pattern signals for the remote control are included in an angle of view desired by the user when the user who has selected the desired angle of view performs the shutter release operation. Accordingly, in the case of using the RC terminal employing the visible light communication, it is necessary to perform processing for appropriately subjecting the visible light pattern signal for the remote control, which is received by the image sensor 101 of the mobile phone 102, to color conversion by the internal image processing. Alternatively, a time difference is set between timing of sensing processing of the visible light pattern signal by the shutter release operation and timing of starting creation processing (image recording operation) of a picture image in response to the shutter release operation, and thus the internal configuration of the mobile phone 102 may be simplified.

Moreover, the above-mentioned respective embodiments have been described taking as an example the case of the mobile phone 102 which is an example of the electronic devices. However, the present invention is not limited to the mobile phone, and for example, can be applied to the electronic devices such as the digital camera and the video camera. Moreover, the present invention is not exclusively limited to the electronic devices excellent in portability, such as the mobile phone and the digital cameras, and can also be applied to stationary electronic devices.

The present invention described with the above-mentioned respective embodiments taken as examples is accomplished in the following manner. A computer program capable of realizing the functions in the flowcharts (in FIGS. 4 and 5) referred to in the description of the mobile phone 102 is supplied to the mobile phone 102. Thereafter, the computer program is read out to the CPU 207 of the device concerned and executed. Moreover, the computer program supplied into the device concerned may be stored in a readable/writable storage device such as the memory 206.

Moreover, in the above-mentioned case, for a method of supplying the computer program into the device concerned, procedures generally used at present can be employed, such as a method of installing the computer program in the device concerned by using an appropriate jig and a method of downloading the computer program from the outside through a communication line such as the Internet at a manufacturing stage before the shipment, a maintenance stage after the shipment, or the like. Moreover, in such a case, the present invention is composed of codes of such a computer program or a storage medium therefor.

According to the respective embodiments and the modification example thereof, which have been described above, the remote control of the electronic device as the remote control target can be easily and reliably realized without using the remote control terminal (RC terminal) dedicated for the electronic device concerned.

While this invention has been described in connection with certain preferred embodiments, it is to be understood that the subject matter encompassed by way of this invention is not to be limited to those specific embodiments. On the contrary, it is intended for the subject matter of the invention to include all alternative, modification and equivalents as can be included within the spirit and scope of the following claims.

## Claims

1. A remote control method for an electronic device (102), **characterized by** comprising:
conditioning (11) the electronic device in a first operation mode;
registering (12, S1 to S3) a signal pattern of a signal received from a remote control terminal (105) desired by a user in association with a predetermined operation of the electronic device when the electronic device conditions in the first operation mode;
operating (11) the electronic device in a second operation mode different from the first operation mode; and
executing (13, 14, S11 to S15) the predetermined operation in a case where a signal pattern of a signal received from the remote control terminal when the electronic device operates in the second operation mode and the signal pattern registered by the registration coincide with each other.

2. The remote control method for an electronic device according to claim 1, **characterized in that**:
the electronic device is a mobile phone having a camera function; and
the signal received by the remote control terminal is sensed by an image sensor (101) for the camera function upon the registering.

3. The remote control method for an electronic device according to claim 2, **characterized in that**, as the predetermined operation, an image sensed by the image sensor is stored in a storage medium upon the executing of the predetermined operation.

4. The remote control method for an electronic device according to any one of claims 1 to 3, **characterized in that**:
the remote control terminal includes plural operation buttons (105A to 105C) in which signal patterns to be sent out are mutually different; and
the signal pattern different for each of the operation buttons, which has been received by the remote control terminal, is registered individually in association with any operation of plural operations of the electronic device upon the registering.

5. An electronic device (102) capable of accepting an operation instruction by remote control, **characterized by** comprising:
signal registration means (12, 101, 206, 207) for registering a signal pattern of a signal received from an outside in a first operation mode in association with a predetermined operation of the electronic device; and
operation control means (13, 14, 207) for executing the predetermined operation in a case where a signal pattern of a signal received from the outside in a second operation mode different from the first operation mode and the signal pattern registered by said signal registration means coincide with each other.

6. The electronic device according to claim 5, **characterized in that** said signal registration means includes sensing means (201, 202) for sensing the signal received from the outside.

7. The electronic device according to claim 6, **characterized in that**:
said electronic device is a mobile phone (102) having a camera function; and
said sensing means is an image sensor (101) for the camera function.

8. The electronic device according to claim 7, **characterized in that** said operation control means stores an image sensed by the image sensor in a storage medium as the predetermined operation.

9. The electronic device according to any one of claims 5 to 8, **characterized in that** said signal registration means registers each signal pattern of the signal received from the outside in association with any of different operations of said electronic device.

10. The electronic device according to any one of claims 5 to 9, **characterized in that**:
the signal received from the outside is an infrared signal, and
said electronic device further comprising infrared receiving means for receiving the infrared signal.

11. A computer program for operation control of an electronic device (102) capable of accepting an operation instruction by remote control, the computer program **characterized by** causing a computer to implement:
a signal registration function (12) to register a signal pattern of a signal received from an outside in a first operation mode in association with a predetermined operation of the electronic device; and
an operation control function (13, 14) to execute the predetermined operation in a case where a signal pattern of a signal received from the outside in a second operation mode different from the first operation mode and the signal pattern registered by the signal registration function coincide with each other.
